(19) Europäisches Patentamt
European Patent Office
Office européen des brevets

(11) **EP 2 211 392 B1**

(12) **EUROPÄISCHE PATENTSCHRIFT**

(45) Veröffentlichungstag und Bekanntmachung des Hinweises auf die Patenterteilung:
**09.01.2013   Patentblatt 2013/02**

(51) Int Cl.:
***C09K 11/80*** *(2006.01)*        ***H01L 33/00*** *(2010.01)*

(21) Anmeldenummer: **10152099.7**

(22) Anmeldetag: **19.11.2001**

(54) **Luminophor und Lichtquelle zur Erzeugung von weißem Licht**

Wavelength converter and light source for generating white light

Elément de conversion de longueur d'onde et source lumineuse émettant de la lumière blanche

(84) Benannte Vertragsstaaten:
**AT BE CH CY DE DK ES FI FR GB GR IE IT LI LU MC NL PT SE TR**

(30) Priorität: **28.12.2000   AT 21542000**

(43) Veröffentlichungstag der Anmeldung:
**28.07.2010   Patentblatt 2010/30**

(60) Teilanmeldung:
**11155555.3 / 2 357 678**

(62) Dokumentnummer(n) der früheren Anmeldung(en) nach Art. 76 EPÜ:
**01272551.1 / 1 352 431**

(73) Patentinhaber:
• **Leuchtstoffwerk Breitungen GmbH**
  **98597 Breitungen (DE)**
• **Tridonic Jennersdorf GmbH**
  **8380 Jennersdorf (AT)**
• **Litec GBR**
  **17489 Greifswald (DE)**
• **Toyoda Gosei Co., Ltd.**
  **Aichi-ken 452-8564 (JP)**

(72) Erfinder:
• **Tasch, Stefan**
  **8380 Jennersdorf (AT)**
• **Pachler, Peter**
  **8010 Graz (AT)**
• **Roth, Gundula**
  **17498 Levenhagen (DE)**
• **Tews, Walter**
  **17489 Greifswald (DE)**
• **Starick, Detlef**
  **17489 Greifswald (DE)**
• **Kempfert, Wolfgang**
  **36448 Bad Liebenstein (DE)**

(74) Vertreter: **Rupp, Christian et al**
**Mitscherlich & Partner**
**Patent- und Rechtsanwälte**
**Postfach 33 06 09**
**80066 München (DE)**

(56) Entgegenhaltungen:
**EP-A2- 1 013 740        WO-A1-00/19546**
**WO-A1-00/33389        WO-A2-01/89001**
**DE-A1- 19 730 006      DE-A1- 19 806 213**
**JP-A- 10 188 649        JP-A- 2000 345 152**
**US-A- 3 505 240**

• **THOMAS L BARRY: "Fluorescence of Eu2+-Activated Phase in Binary Alkaline Earth Orthosilicate systems", JOURNAL OF THE ELECTROCHEMICAL SOCIETY, ELECTROCHEMICAL SOCIETY. MANCHESTER, NEW HAMPSHIRE, US, vol. 115, no. 11, 1 November 1968 (1968-11-01), pages 1181-1184, XP002631112, ISSN: 0013-4651, DOI: DOI: 10.1149/1.2410935**

**Beschreibung**

TECHNISCHES GEBIET

Die vorliegende Erfindung betrifft eine Lichtquelle mit einem Licht emittierenden Element, das in einem ersten Spektralbereich, vorzugsweise im blauen und/oder ultravioletten Bereich des optischen Spektrums, emittiert, und mit einem Luminophor, der entweder aus der Gruppe der Erdalkaliorthosilikate stammt oder zumindest einen Anteil aus dieser Leuchtstoffgruppe enthält und der einen Teil der Emission des Licht emittierenden Elements absorbiert und in einem anderen Spektralbereich, vorzugsweise im gelb-grünen, gelben oder orangefarbigen Bereich, emittiert. Der ausgewählte Luminophor kann auch in Mischungen mit anderen Luminophoren dieser Gruppe und/oder mit weiteren Leuchtstoffen, die nicht zu dieser Gruppe gehören, eingesetzt werden.

Das Licht emittierende Element ist vorzugsweise eine anorganische LED, es kann aber auch eine organische LED, eine Laserdiode, eine anorganische Dickschichtelektrolumineszenzfolie oder ein anorganisches Dünnschichtelektrolumineszenzbauelement sein.

STAND DER TECHNIK

Anorganische LEDs zeichnen sich unter anderem durch hohe Lebensdauer, geringen Platzbedarf, Erschütterungsunempfindlichkeit und spektral engbandige Emission aus.

Zahlreiche Emissionsfarben - speziell spektral breitbandige - können mittels der intrinsischen Emission eines aktiven Halbleitermaterials in LEDs nicht oder nur ineffizient realisiert werden. Vor allem trifft dies auf die Erzeugung von weissem Licht zu.

Gemäß dem Stand der Technik werden Emissionsfarben, welche mit dem Halbleiter intrinsisch nicht realisiert werden können, mittels Farbkonversion erzeugt.

Im Wesentlichen basiert die Technik der Farbkonversion auf dem Prinzip, dass zumindest ein Luminophor über dem LED-Die angeordnet wird. Dieser absorbiert einen Teil der vom Die emittierten Strahlung und wird dabei zur Photolumineszenz angeregt. Die Emissions- bzw. Lichtfarbe der Quelle ergibt sich dann aus der Mischung der transmittierten Strahlung des Die und der emittierten Strahlung des Leuchtstoffes.

Als Luminophore können grundsätzlich sowohl organische als auch anorganische Systeme eingesetzt werden. Der wesentliche Vorteil anorganischer Pigmente liegt in der höheren chemischen, Temperatur- und Strahlungsstabilität im Vergleich zu organischen Systemen. Im Zusammenhang mit der hohen Lebensdauer der anorganischen LEDs sichern langlebige anorganische Luminophore eine hohe Farbortstabilität der aus beiden Komponenten bestehenden Lichtquelle.

Soll die von blau emittierenden LEDs ausgesendete Strahlung in weisses Licht konvertiert werden, werden Leuchtstoffe benötigt, die das blaue Licht (450-490 nm) wirkungsvoll absorbieren und mit hoher Effizienz in grösstenteils gelbe Lumineszenzstrahlung umwandeln. Allerdings gibt es nur eine geringe Anzahl anorganischer Luminophore, die diese Anforderungen erfüllen. Derzeit werden zumeist Materialien aus der YAG-Leuchtstoffklasse als Farbkonversionspigmente für blaue LEDs eingesetzt ( WO 98/05078 ; WO 98/05078 ; WO 98/12757 ). Diese weisen allerdings den Nachteil auf, dass sie nur bei einem Emissionsmaximum kleiner als 560 nm eine genügend hohe Effizienz besitzen. Aus diesem Grund können mit den YAG-Pigmenten in Kombination mit blauen Dioden (450-490 nm) nur kalt-weisse Lichtfarben mit Farbtemperaturen zwischen 6000 und 8000 K und mit vergleichsweise niedriger Farbwiedergabe (typische Werte für den Farbwiedergabeindex Ra liegen zwischen 70 und 75) realisiert werden. Daraus ergeben sich stark eingeschränkte Anwendungsmöglichkeiten. Zum einen werden bei der Anwendung von Weisslichtquellen in der Allgemeinbeleuchtung in der Regel höhere Anforderungen an die Farbwiedergabequalität der Leuchtmittel gestellt, und zum anderen werden von den Konsumenten vor allem in Europa und in Nordamerika wärmere Lichtfarben mit Farbtemperaturen zwischen 2700 und 5000 K bevorzugt.

Aus der WO 00/33389 ist weiterhin bekannt, u.a. Ba2SiO4:Eu<2+> als Luminophor zur Konvertierung des Lichtes blauer LEDs zu verwenden. Das Maximum der Emission des Leuchtstoffes Ba2SiO4:Eu<2+> liegt aber bei 505 nm, so dass mit einer solchen Kombination mit Sicherheit kein weisses Licht erzeugt werden kann.

In der Arbeit von S.H.M. Poort et al: "Optical properties of Eu2+-activated orthosilicates and orthophospates", Journal of Alloys and Compounds 260 (1997), S. 93-97 werden die Eigenschaften von Eu-aktiviertem Ba2SiO4 sowie von Phosphaten wie KBaPO4 und KSrP04 untersucht. Auch hier wird festgestellt, dass die Emission von Ba2SiO4 bei etwa 505 nm liegt.

WO 01/89001 zeigt ein Leuchtstoffsystem aufweisend eine LED Lichtquelle und wenigstens drei unterschiedliche Leuchtstoffe. Dabei werden ein erster orange emittierender Leuchtstoff, ein zweiter blau-grün emittierender Leuchtstoff und ein dritter blau emittierender Leuchtstoff bereitgestellt. Durch die Mischung der emittierten Strahlung der drei unterschiedlichen Leuchtstoffe wird weißes Licht durch den menschlichen Betrachter wahrgenommen.

WO 00/19546 beschreibt ein Beleuchtungssystem aufweisend wenigstens zwei LED Lichtquellen für die Bereitstellung von sichtbarem Licht in vordefinierten Wellenlängen und einen grün emittierenden Leuchtstoff als Konversionsmittel für die Umwandlung von wenigstens einem Teil des sichtbaren Lichts, welches von einer der zwei LEDs abgegeben wird, in sichtbares Licht einer anderen Wellenlänge, um die Farbwiedergabe des Beleuchtungssystems zu optimieren.

In der Arbeit von Thomas L Barry: "Fluorescence of EU2+ - activated phase in binary alkaline earth orthosilicate systems", Journal of the Electrochemical Society, Manchester, New Hampshire, Bd. 115, Nr. 11, 1. November 1968, Seiten 1181-1184, XP002631112, wird die Emission eines (Ba,Sr)SiO4- und eines (Ca,Sr) SiO4-Leuchtstoffsystems bei der Anregung mit Hilfe von ultraviolettem Licht untersucht.

US 3 505 240 zeigt ein Leuchtstoffsystem, welches durch ultraviolette Strahlung einer Quecksilberdampflampe im Bereich von 253 und 365nm angeregt wird. Die emittierte Strahlung der Quecksilberdampflampe wird dabei vorzugsweise komplett in sichtbares Licht umgewandelt.

OFFENBARUNG DER ERFINDUNG

Es ist Aufgabe der vorliegenden Erfindung, eine Lichtquelle der eingangs genannten Art so abzuändern, dass mit ihr bei gleichzeitig hoher Lichtausbeute und hoher Farbwiedergabequalität Weisslichtfarben mit wärmeren Farbtemperaturen erzeugt werden können, insbesondere diejenigen Farborte, die innerhalb der von der CIE für die Allgemeinbeleuchtung festgelegten Toleranzellipsen liegen.

Diese Aufgabe wird durch den Gegenstand des unabhängigen Schutzanspruchs 1 gelöst. Vorteilhafte Ausführungsformen der erfindungsgemäßen Lichtquelle sind Gegenstand der abhängigen Schutzansprüche und ergeben sich aus der nachfolgenden Beschreibung der Erfindung.

Erfindungsgemäß wird eine Lichtquelle zur Erzeugung von weißem Licht bereitgestellt, umfassend eine Lichtemittierende-Diode (LED) zur Emission einer blauen Strahlung und mindestens einen Luminophor, der einen Teil der blauen Strahlung absorbiert und selbst Strahlung in einem anderen Spektralbereich emittiert, dadurch gekennzeichnet, dass er

- ein mit zweiwertigem Europium aktiviertes Erdalkaliorthosilikat einer der nachfolgenden Zusammensetzungen oder einer Mischung aus diesen Zusammensetzungen ist:

  a) $(2-x-y)SrO \cdot x (Ba_u, Ca_v) O \cdot (1-a-b-c-d>SiO_2 \cdot aP_2O_5 \, bAl_2O_3 \, cB_2O_3 \, dGeO_2 : yEu^{2+}$ wobei
  $0<=x<1,6 \quad 0,005 <y< 0,5 \quad x+y<=1,6$
  $0<=a,b,c,d<0,5 \quad u+v=1$ gilt,
  b) $<2-x-y>BaO \cdot x(Sr_u, Ca_v)O \cdot (1-a-b-c-d)SiO_2 \cdot aP_2O_5 \, bAl_2O_3 \, cB_2O_3 \, dGeO_2: yEu^{2+}$ wobei
  $0,01 <x< 1,6 \quad 0,005 < y < 0,5 \quad 0<=a,b,c,d< 0,5 \quad u+v=1 \quad x \cdot u>=0,4$ gilt;

- Strahlung im gelb-grünen, gelben oder orangefarbigen Spektralbereich emittiert,

- ein Luminophorgitter aufweiset, in welches zusätzliche einwertige Ionen eingebaut sind, die durch Halogenide und/ oder Alkalimetallionen gebildes sind, wobei das weiße Licht durch Mischung des transmittierenden Lichts der LED und des emittierten Lumineszenzlichts des Luminophors generiert wird.

In einer bevorzugten Ausführungsform ist zumindest einer der Werte a, b, c und d grösser als 0,01. Es kann dabei in beiden Formeln ein Teil des Siliziums durch Gallium ersetzt sein.

Überraschenderweise wurde gefunden, dass weisses Licht mit guter Farbwiedergabe und hoher Lichtausbeute durch Kombination einer blauen LED mit einem Luminophor, ausgewählt aus der Gruppe der erfindungsgemäßen europiumaktivierten Erdalkaliorthosilikate oben genannter Zusammensetzung, realisiert werden kann. Im Gegensatz zu Luminophoren, die auf reinen Bariumorthosilikaten basieren und bläulich-grünes Licht ausstrahlen, kann nämlich durch Barium-Strontium-OrthosilikatMischkristalle gelb-grünes, gelbes bis gelb-orangefarbenes und durch Einbau von Calcium in das Orthosilikatgitter sogar vollständig orangefarbenes Lumineszenzlicht erzeugt werden, so dass dann durch Mischung des transmittierten Lichtes der blauen LED und des emittierten Lumineszenzlichtes des ausgewählten Luminophors weißes Licht hoher Farbwiedergabe und hoher Effizienz generiert werden kann. Die Verschiebung der Emissionsfarbe durch Substitution von Ba durch Sr in Orthosilikaten war bisher nur für die Anregung mit harter UV-Strahlung (254 nm-Anregung) aus der oben genannten Arbeit von Poort et al. bekannt; dass dieser Effekt überraschender Weise verstärkt bei der Bestrahlung mit blauem Licht im Bereich von 440-475 nm auftritt, wurde dagegen noch nicht beschrieben. Ba-Sr-Ca-Orthosilikatmischkristalle und ihr starkes Emissionsvermögen bei Anregung mit langweiliger UV-Strahlung oder blauem Licht waren bisher gänzlich unbekannt.

Der ausgewählte Luminophor kann auch in Mischungen mit anderen Luminophoren dieser Gruppe und/oder mit zusätzlichen Leuchtstoffen, die nicht zu dieser Gruppe gehören, eingesetzt werden. Zu den letztgenannten Leuchtstoffen gehören z.B. blau emittierende Erdalkalialuminate, aktiviert mit zweiwertigem Europium und/oder Mangan, sowie die rot emittierenden Luminophore aus der Gruppe Y(V,P,Si)O$_4$ : Eu,Bi, Y$_2$O$_2$S:Eu,Bi oder aber europium- und manganaktivierte Erdalkali-Magnesium-disilikate: Eu$^{2+}$, Mn$^{2+}$ der Formel

$$Me_{(3-x-y)} \, MgSi_2O_8: xEu, yMn,$$

mit

$$0,005 < x < 0,5$$

$$0,005 < y < 0,5$$

und Me = Ba und/oder Sr und/oder Ca.

Wie in den unten angeführten Ausführungsbeispielen gezeigt wird, darf der Sr-Anteil in den erfindungsgemäßen Mischkristall-Luminophoren nicht zu gering sein, um weißes Licht generieren zu können.

Überraschender Weise wurde weiters gefunden, dass der zusätzliche Einbau von P$_2$O$_5$, Al$_2$O$_3$ und/oder B$_2$O$_3$ in das Orthosilikatgitter sowie die Substitution eines Teils des Siliziums durch Germanium ebenfalls einen beträchtlichen Einfluss auf das Emissionsspektrum des jeweiligen Luminophors haben, so dass dieses für den jeweiligen Anwendungsfall in vorteilhafter Weise weiter variiert werden kann. Dabei bewirken kleinere Ionen als Si(IV) im Allgemeinen eine Verschiebung des Emissionsmaximum in den längerwelligen Bereich, während größere Ionen den Emissionsschwerpunkt zu kürzeren Wellenlängen verschieben. Weiterhin konnte gezeigt werden, dass es für die Kristallinität, das Emissionsvermögen und insbesondere für die Stabilität der erfindungsgemäßen Luminophore vorteilhaft sein kann, wenn zusätzlich geringe Mengen einwertiger Ionen wie z.B. Halogenide und/oder Alkalimetallionen in das Luminophorgitter eingebaut werden.

Gemäß einer weiteren vorteilhaften Ausgestaltung der Erfindung weist die Lichtquelle zumindest zwei verschiedene Luminophore auf, wobei zumindest einer ein Erdalkaliorthosilikatleuchtstoff ist. Auf diese Weise lässt sich der für die jeweilige Anwendung geforderte Weißton besonders genau einstellen und es lassen sich insbesondere Ra-Werte größer 80 erreichen. Eine weitere vorteilhafte Variante der Erfindung besteht in der Kombination einer im ultravioletten Bereich des Spektrums, beispielsweise im Bereich zwischen 370 und 390 nm, emittierenden LED mit zumindest drei Leuchtstoffen, von denen zumindest einer ein erfindungsgemäßer Erdalkaliorthosilikatleuchtstoff ist. Als zusätzliche Leuchtstoffe können in den entsprechenden Leuchtstoffmischungen blau emittierende Erdalkalialuminate, aktiviert mit Europium und/oder Mangan und/oder rot emittierende Luminophore aus der Gruppe Y(V,P,Si)O$_4$:Eu,Bi, Y$_2$O$_2$S:Eu,Bi oder aber aus der Gruppe der europium- und manganaktivierten Erdalkali-Magnesium-disilikate eingesetzt werden.

Für die mechanische Ausführung der erfindungsgemäßen Lichtquelle gibt es mehrere Möglichkeiten. Gemäß einer Ausführungsform ist vorgesehen, dass ein oder mehrere LED-Chips auf einer Leiterplatte innerhalb eines Reflektors angeordnet sind und der Luminophor in einer Lichtscheibe, die über dem Reflektor angeordnet ist, dispergiert ist.

Es ist aber auch möglich, dass ein oder mehrere LED-Chips auf einer Leiterplatte innerhalb eines Reflektors angeordnet sind und der Luminophor auf dem Reflektor aufgebracht ist.

Vorzugsweise sind die LED-Chips mit einer transparenten Vergussmasse, die kuppelartige Form besitzt, vergossen. Diese Vergussmasse bildet einerseits einen mechanischen Schutz, andererseits verbessert sie auch die optischen Eigenschaften (besserer Austritt des Lichts aus den LED-Dice).

Der Luminophor kann auch in einer Vergussmasse dispergiert sein, die eine Anordnung von LED-Chips auf einer Leiterplatte und eine Polymerlinse möglichst ohne Gaseinschlüsse verbindet, wobei die Polymerlinse und die Vergussmasse Brechungsindizes aufweisen, die sich maximal um 0,1 unterscheiden. Diese Vergussmasse kann direkt die LED-Dice einschließen, es ist aber auch möglich, dass diese mit einer transparenten Vergussmasse vergossen sind (dann gibt es also eine transparente Vergussmasse und eine Vergussmasse mit dem Luminophor). Durch die ähnlichen Brechungsindizes gibt es an den Grenzflächen kaum Verluste durch Reflexion.

Vorzugsweise weist die Polymerlinse eine kugel- bzw. ellipsoidförmige Ausnehmung auf, welche durch die Vergussmasse ausgefüllt ist, sodass das LED-Array in geringem Abstand zur Polymerlinse befestigt ist. Auf diese Weise kann die Höhe des mechanischen Aufbaus verringert werden.

Um eine gleichmäßige Verteilung des Luminophors zu erreichen, ist es zweckmäßig, wenn der Luminophor in einer vorzugsweise anorganischen Matrix aufgeschlämmt ist.

Bei Verwendung von zumindest zwei Luminophoren ist es günstig, wenn die zumindest zwei Luminophore einzeln in Matrizen dispergiert sind, die in Lichtausbreitung hintereinander angeordnet sind. Dadurch kann die Konzentration der Luminophore im Vergleich zu einer einheitlichen Dispersion der verschiedenen Luminophore reduziert werden.

Nachfolgend sind die wesentlichen Schritte zur Herstellung der Luminophore in einer bevorzugten Variante der Erfindung dargestellt:

Für die Herstellung der Erdalkaliorthosilikat-Luminophore werden entsprechend der gewählten Zusammensetzung die stöchiometrischen Mengen der Ausgangsstoffe Erdalkalicarbonat, Siliciumdioxid sowie Europiumoxid innig gemischt und in einer für die Leuchtstoffherstellung üblichen Festkörperreaktion in reduzierender Atmosphäre bei Temperaturen zwischen 1100°C und 1400°C in den gewünschten Luminophor umgewandelt. Dabei ist es für die Kristallinität von Vorteil, der Reaktionsmischung kleine Anteile, vorzugsweise kleiner als 0,2 Mol, Ammoniumchlorid oder andere Halogenide zuzugeben. Im Sinne der aufgezeigten Erfindung kann auch ein Teil des Siliziums durch Germanium, Bor, Aluminium, Phosphor ersetzt werden, was durch Zugabe entsprechender Mengen von Verbindungen der genannten Elemente, die sich thermisch in Oxide zersetzen lassen, realisiert wird. In ähnlicher Weise kann erreicht werden, dass geringe Mengen von Alkalimetallionen in das jeweilige Gitter eingebaut werden.

Die erhaltenen erfindungsgemäßen Orthosilikatluminophore emittieren bei Wellenlängen zwischen etwa 510 nm und 600 nm und besitzen eine Halbwertsbreite bis zu 110 nm.

Durch entsprechende Gestaltung der Reaktionsparameter und durch bestimmte Zusätze, z.B. von einwertigen Halogenid-und/oder Alkalimetallionen, kann die Korngrößenverteilung der erfindungsgemäßen Luminophore an die Anforderungen der jeweiligen Anwendung optimal angepasst werden, ohne dass schädigende mechanische Zerkleinerungsprozesse durchgeführt werden müssen. Auf diese Weise lassen sich alle schmal- und breitbandigen Korngrößenverteilungen mit mittleren Korngrößen $d_{50}$ von etwa 2 $\mu$m bis 20 $\mu$m einstellen.

Die erfindungsgemäße Lichtquelle enthält bevorzugt einen zusätzlichen Luminophor aus der Gruppe der Erdalkalialuminate, aktiviert mit zweiwertigem Europium und/oder Mangan, und/oder einen weiteren zusätzlichen rotemittierenden Luminophor aus der Gruppe **$Y(V,P,Si)O_4$ :Eu,Bi, $Y_2O_2S$:Eu,Bi** oder Erdalkali-Magnesiumdisilikat : **$Eu^{2+},Mn^{2+}$** der Formel **$Me_{(3-x-y)}MgSi_2O_8$:xEu,yMn**, wobei **0,005 < x < 0,5; 0,005 < y < 0,5** und **Me = Ba** und/oder **Sr** und/oder **Ca** gilt.

Der erste Spektralbereich der erfindungsgemäßen Lichtquelle liegt bevorzugt zwischen 300 und 500 nm. Der zweite Spektralbereich der erfindungsgemäßen Lichtquelle liegt bevorzugt zwischen 430 und 650 nm. Die erfindungsgemäße Lichtquelle strahlt bevorzugt weißes Licht mit Ra-Werten > 70, besonders bevorzugt > 72, aus.

Die erfindungsgemäße Lichtquelle weist bevorzugt zumindest zwei verschiedene Luminophore auf, wobei zumindest einer ein Erdalkaliorthosilikatleuchtstoff ist.

Ein oder mehrere LED-Chips sind bevorzugt auf einer Leiterplatte innerhalb eines Reflektors der erfindungsgemäßen Lichtquelle angeordnet. Dabei ist der Luminophor in einer Lichtscheibe, die über dem Reflektor angeordnet ist, dispergiert. Alternativ sind bevorzugt ein oder mehrere LED-Chips auf einer Leiterplatte innerhalb eines Reflektors angeordnet,

wobei der Luminophor auf dem Reflektor aufgebracht ist. Die LED-Chips sind bevorzugt mit einer transparenten Vergussmasse, die eine kuppelartige Form besitzt, vergossen. Der Luminophor der erfindungsgemäßen Lichtquelle ist bevorzugt in einer Vergussmasse dispergiert, die eine Anordnung von LED-Chips auf einer Leiterplatte und eine Polymerlinse möglichst ohne Gaseinschlüsse verbindet, wobei die Polymerlinse und die Vergussmasse Brechungsindizes aufweisen, die sich maximal um 0,1 unterscheiden. Die Polymerlinse weist bevorzugt eine kugel- bzw. ellipsoidförmige Ausnehmung auf, welche durch die Vergussmasse ausgefüllt ist, sodass das LED-Array in geringem Abstand zur Polymerlinse befestigt ist. Der Luminophor ist bevorzugt in einer vorzugsweise anorganischen Matrix aufgeschlämmt.

Bei einer bevorzugten Ausführungsform sind zumindest zwei der Luminophore einzeln in Matrizen dispergiert, die in Lichtausbreitung hintereinander angeordnet sind.

Die mittlere Korngröße $d_{50}$ der Volumenverteilung liegt bevorzugt zwischen 2 $\mu$m und 20 $\mu$m.

KURZE BESCHREIBUNG DER ZEICHNUNGEN

Weitere Vorteile der Erfindung werden im Folgenden anhand von Ausführungsbeispielen und Figuren erläutert.

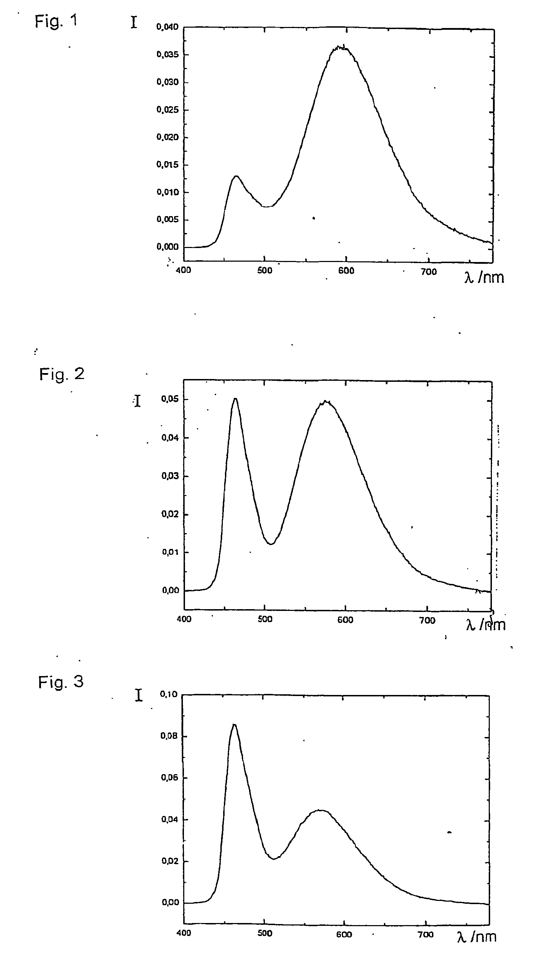

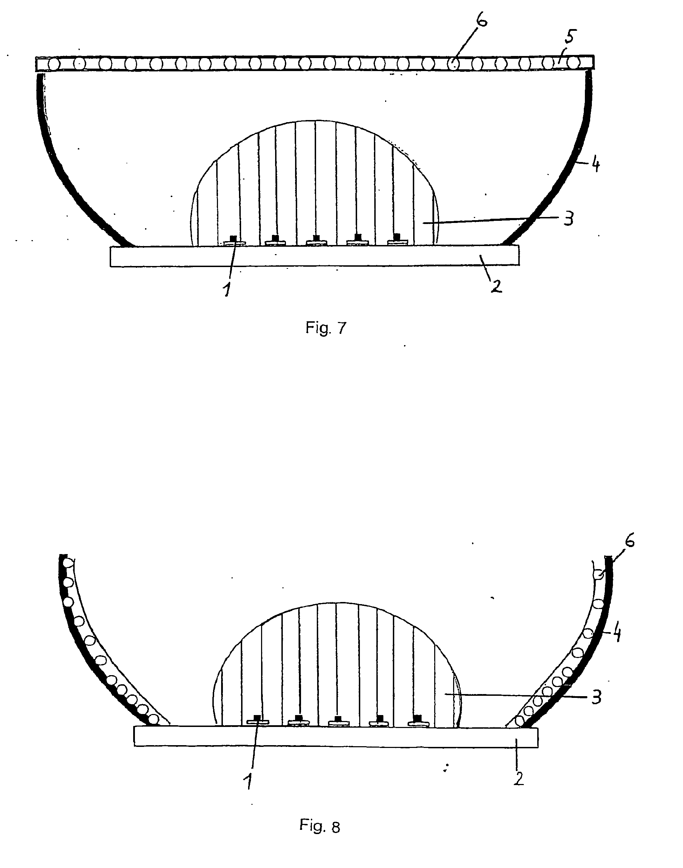

Fig. 1-6 zeigen Spektren (relative Intensität I abhängig von der Wellenlänge) verschiedener erfindungsgemäßer LED-Lichtquellen; und die Fig. 7-10 zeigen verschiedene Ausführungsformen erfindungsgemäßer LED-Lichtquellen.

BESTE AUSFÜHRUNGSFORMEN DER ERFINDUNG

Fig. 1 zeigt das Emissionsspektrum einer weißen LED mit einer Farbtemperatur von 2700 K, die durch Kombination einer in einem ersten Spektralbereich mit einer Schwerpunktswellenlänge von 464 nm emittierenden blauen LED und einem erfindungsgemäßen Luminophor der Zusammensetzung ($Sr_{1,4}Ca_{0,6}SiO_4$:$Eu^{2+}$), der in einem zweiten Spektralbereich mit einem Maximum von 596 nm emittiert, entstanden ist.

Weitere Beispiele für die Kombination einer bei 464 nm emittierenden LED mit jeweils einem der erfindungsgemäßen Orthosilikatluminophore sind in den Fig. 2 und 3 dargestellt. Wird ein gelb emittierender Luminophor der Zusammensetzung $Sr_{1,90}Ba_{0,08}Ca_{0,02}SiO_4$:$Eu^{2+}$ zur Farbkonvertierung verwendet, kann eine Weißlichtfarbe mit einer Farbtemperatur von 4100 K eingestellt werden, während bei der Verwendung des Luminophors $Sr_{1,84}Ba_{0,16}SiO_4$:$Eu^{2+}$

beispielsweise eine Weißlichtquelle mit einer Farbtemperatur von 6500 K gefertigt werden kann.

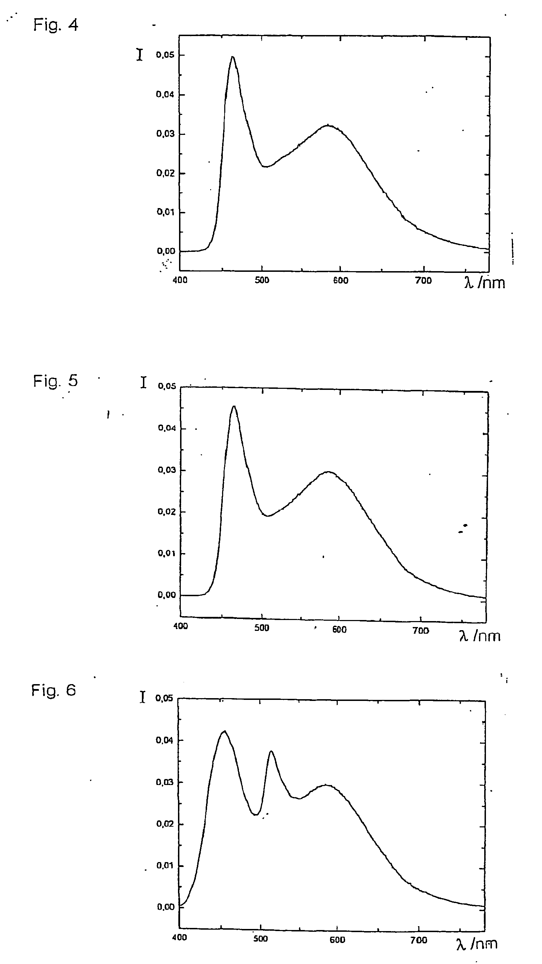

Ein typisches Spektrum für die Kombination einer 464 nm - LED mit zwei erfindungsgemäßen Orthosilikatluminophoren zeigt Fig. 4. Die verwendeten Leuchtstoffe weisen die Zusammensetzungen $Sr_{1,4}Ca_{0,6}SiO_4:Eu^{2+}$ und $Sr_{1,00}Ba_{1,00}SiO_4:Eu^{2+}$ auf. Für das in der Abbildung 4 dargestellte konkrete Spektrum werden eine Farbtemperatur von 5088 K und ein Farbwiedergabeindex Ra von 82 erhalten. Allerdings können in Abhängigkeit von den gewählten Mengenverhältnissen der Luminophore alle Farbtemperaturen im Bereich zwischen etwa 3500 K und 7500 K realisiert werden, wobei der große Vorteil derartiger Mischungen aus zwei erfindungsgemäßen Erdalkaliorthosilikat-Luminophoren vor allem darin besteht, dass zugleich Ra-Werte größer 80 erreicht werden können.

Das wird in der Fig. 5 beispielhaft dokumentiert. Das dargestellte Spektrum steht für die Kombination einer 464 nm - LED mit einer Mischung aus den zwei Luminophoren $Sr_{1,6}Ca_{0,4}Si_{0,98}Ga_{0,02}O_4:Eu^{2+}$ und $Sr_{1,10}Ba_{0,90}SiO_4:Eu^{2+}$ und liefert bei einer Farbtemperatur von 5000 K einen Ra-Werte von 82.

Wird als strahlungsemittierendes Element eine UV-LED verwendet, die in einem ersten Spektralbereich mit einem Maximum von 370-390 nm emittiert, dann lassen sich durch Kombination einer solchen LED mit einer Leuchtstoffmischung, die die erfindungsgemäßen Luminophore von Fig. 4 und zugleich einen bestimmten Anteil eines blaugrün emittierenden Barium-Magnesium-Aluminatleuchtstoff:Eu,Mn enthält, Ra-Werte größer 90 realisieren. Die Fig. 6 zeigt das Emissionsspektrum einer entsprechenden Weißlichtquelle, die bei einer Farbtemperatur von 6500 K einen Ra von 91 aufweist.

Weitere Bespiele sind der folgenden Aufstellung zu entnehmen. Dabei wurden neben der Emissionswellenlänge der verwendeten anorganischen LED und der jeweiligen Zusammensetzung der erfindungsgemäßen Luminophore die resultierenden Farbtemperaturen und Ra-Werte sowie die Farborte der Lichtquellen angegeben:

T = 2778 K (464 nm + $Sr_{1,4}Ca_{0,6}SiO_4:Eu^{2+}$) ; x = 0,4619, y = 0,4247, Ra 72

T = 2950 K (464 nm + $Sr_{1,4}Ca_{0,6}SiO_4:Eu^{2+}$) ; x = 0,4380, y = 0,4004, Ra = 73

T = 3497 K (464 nm + $Sr_{1,4}Ca_{0,6}SiO_4:Eu^{2+}$) ; x = 0,4086, y = 0,3996, Ra = 74

T = 4183 K (464 nm + $Sr_{1,9}Ba_{0,08}Ca_{0,02}SiO_4:Eu^{2+}$); x = 0,3762, y = 0,3873, Ra = 75

T = 6624 K (464 nm + $Sr_{1,9}Ba_{0,02}Ca_{0,08}SiO_4:Eu^{2+}$); x = 0,3101, y = 0,3306, Ra = 76

T = 6385 K (464 nm + $Sr_{1,6}Ca_{0,4}SiO_4 : Eu^{2+} + Sr_{0,4}Ba_{1,6}SiO_4 : Eu^{2+}$) ; x = 0,3135, y = 0,3397, Ra = 82

T = 4216 K (464 nm + $Sr_{1,9}Ba_{0,08}Ca_{0,02}SiO_4:Eu^{2+}$); x = 0,3710, y = 0,3696, Ra = 82

3954 K (464 nm + $Sr_{1,6}Ba_{0,4}SiO_4:Eu^{2+} + Sr_{0,4}Ba_{1,6}SiO_4:Eu^{2+}$ $YVO_4:Eu^{3+}$); x = 0,3756, y = 0,3816, Ra = 84

T = 6489 K (UV-LED + $Sr_{1,6}Ca_{0,4}SiO_4:Eu^{2+} + Sr_{0,4}Ba_{1,6}SiO_4:Eu^{2+}$ Barium-Magnesium-Aluminat: $Eu^{2+}$); x = 0,3115, y = 0,3390, Ra = 86

T = 5097 K (464 nm + $Sr_{1,6}Ba_{0,4}(Si_{0,98}B_{0,02})O_4:Eu^{2+}$ + $Sr_{0,6}Ba_{1,4}SiO_4 :Eu^{2+}$); x = 0,3423, y = 0,3485, Ra = 82

T = 5084 K (UV-LED + $Sr_{1,6}Ca_{0,4}(Si_{0,99}B_{0,01})O_4:Eu^{2+}$ + $Sr_{0,6}Ba_{1,4}SiO_4:Eu^{2+}$ +Strontium-Magnesium-Aluminat: $Eu^{2+}$) ; x = 0,3430, y = 0,3531, Ra = 83

T = 3369 K (464 nm + $Sr_{1,4}Ca_{0,6}Si_{0,95}Ge_{0,05}O_4:Eu^{2+}$) ; x = 0,4134, y = 0,3959, Ra = 74

T = 2787 K (466 nm + $Sr_{1,4}Ca_{0,6}Si_{0,98}P_{0,02}O_{4,01}:Eu^{2+}$) x = 0, 4630, y = 0,4280, Ra = 72

T = 2913 K (464 nm + $Sr_{1,4}Ca_{0,6}Si_{0,98}Al_{0,02}O_4:Eu^{2+}$); x = 0, 4425, y = 0,4050, Ra = 73

T= 4201 K

In einer bevorzugten Variante der Erfindung wird die Farbkonversion folgendermaßen durchgeführt:

Ein oder mehrere LED-Chips 1 (siehe Fig. 7) werden auf einer Leiterplatte 2 assembliert. Direkt über den LEDs wird (einerseits zum Schutz der LED-Chips und andererseits um das im LED-Chip erzeugte Licht besser auskoppeln zu können) ein Einkapselmittel 3 in der Form einer Halbkugel oder eines Halbellipsoids angeordnet. Dieses Verkapselmittel 3 kann entweder jeden Die einzeln umfassen, oder es kann eine gemeinsame Form für alle LEDs darstellen. Die derart bestückte Leiterplatte 2 wird in einen Reflektor 4 eingesetzt bzw. dieser wird über die LED-Chips 1 gestülpt.

Auf den Reflektor 4 wird eine Lichtscheibe 5 gesetzt. Diese dient einerseits dem Schutz der Anordnung, anderseits werden in diese Lichtscheibe die Luminophore 6 eingemischt. Das blaue Licht (oder die ultraviolette Strahlung), das durch die Lichtscheibe 5 hindurchtritt, wird beim Durchgang anteilig durch den Luminophor 6 in einen zweiten Spektralbereich konvertiert, so dass sich insgesamt ein weißer Farbeindruck ergibt. Verluste durch waveguiding-Effekte, wie diese bei planparallelen Platten auftreten, werden durch die opaken, streuenden Eigenschaften der Scheibe reduziert. Weiterhin sorgt der Reflektor 4 dafür, dass nur bereits vorgerichtetes Licht auf die Lichtscheibe 5 auftrifft, so dass Totalreflexionseffekte von vornherein reduziert werden.

Es ist auch möglich, den Luminophor 6 auf den Reflektor 4 aufzutragen, wie dies in Fig. 8 dargestellt ist. Es ist dann keine Lichtscheibe erforderlich.

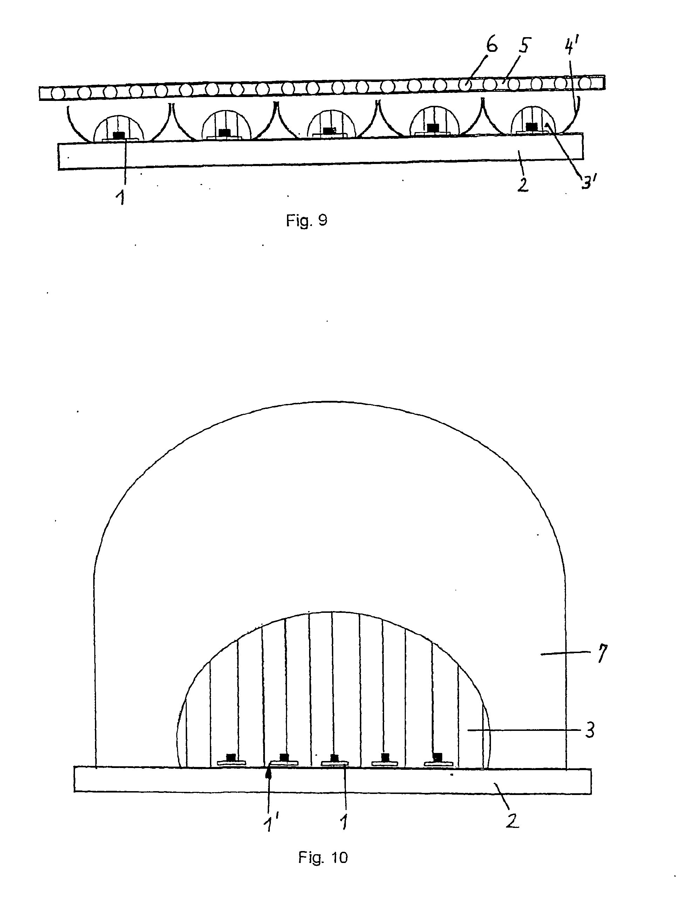

Alternativ dazu kann über jedem LED-Chip 1 (siehe Fig. 9) ein Reflektor 4' aufgesetzt sein und dieser kuppelförmig ausgegossen werden (Einkapselmittel 3') und eine Lichtscheibe 5 über jedem Reflektor 3' bzw. über der gesamten Anordnung angeordnet werden.

Für die Herstellung von Beleuchtungsquellen ist es zweckmäßig, anstelle von Einzel-LEDs LED-Arrays zu verwenden. In einer bevorzugten Variante der Erfindung wird die Farbkonversion auf einem LED-Array 1' (siehe Fig.

10), bei welchem die LED-Chips 1 direkt auf der Leiterplatte 2 assembliert werden, in folgender Form durchgeführt:

Ein LED-Array 1' (siehe Fig. 10) wird mittels einer Vergussmasse 3 (z.B. Epoxid) an eine transparente Polymerlinse 7, die aus einem anderen Material (z.B. PMMA) besteht, angeklebt. Das Material der Polymerlinse 7 und der Vergussmasse 3 werden derart ausgewählt, dass diese möglichst ähnliche Brechzahlen aufweisen - also phasenangepasst sind. Die Vergussmasse 3 befindet sich in einer maximal kugelförmigen oder ellipsoidförmigen Aushöhlung der Polymerlinse 7. Die Form der Aushöhlung ist insofern von Bedeutung, da in der Vergussmasse 3 das Farbkonversionsmaterial dispergiert ist, und daher durch die Formgebung sichergestellt werden kann, dass winkelunabhängige Emissionsfarben erzeugt werden. Alternativ dazu kann das Array zuerst mit einer transparenten Vergussmasse vergossen werden und anschließend mittels der Vergussmasse, die das Farbkonversionsmaterial beinhaltet, an die Polymerlinse geklebt werden.

Zur Herstellung weißer LEDs mit besonders guter Farbwiedergabe, bei denen zumindest zwei verschiedene Luminophore eingesetzt werden, ist es günstig, diese nicht gemeinsam in einer Matrix zu dispergieren, sondern diese getrennt zu dispergieren und aufzubringen. Dies gilt speziell für Kombinationen, bei denen die endgültige Lichtfarbe durch einen mehrstufigen Farbkonversionsprozess erzeugt wird. D.h., dass die langwelligste Emissionsfarbe durch einen Emissionsprozess generiert wird, der wie folgt abläuft: Absorption der LED-Emission durch den ersten Luminophor - Emission des ersten Luminophors - Absorption der Emission des ersten Luminophors durch den zweiten Luminophor und Emission des zweiten Luminophors. Speziell für einen derartigen Prozess ist es zu bevorzugen, die einzelnen Materialien in Lichtausbreitungsrichtung hintereinander anzuordnen, da damit die Konzentration der Materialien im Vergleich zu einer einheitlichen Dispersion der verschiedenen Materialien reduziert werden kann.

Die vorliegende Erfindung ist nicht auf die beschriebenen Beispiele eingeschränkt. Die Luminophore könnten auch in der Polymerlinse (oder einer anderen Optik) eingebracht sein. Es ist auch möglich, den Luminophor direkt über dem LED-Dice oder auf der Oberfläche der transparenten Vergussmasse anzuordnen. Auch kann der Luminophor zusammen mit Streupartikeln in eine Matrix eingebracht werden. Dadurch wird ein Absinken in der Matrix verhindert und ein gleichmäßiger Lichtaustritt gewährleistet.

## Patentansprüche

1. Lichtquelle zur Erzeugung von weißem Licht, umfassend eine Licht-emittierende-Diode (LED) zur Emission einer blauen Strahlung und mindestens einen Luminophor, der einen Teil der blauen Strahlung absorbiert und selbst Strahlung in einem anderen Spektralbereich emittiert, **dadurch gekennzeichnet, dass** er

   - ein mit zweiwertigem Europium aktiviertes Erdalkaliorthosilikat einer der nachfolgenden Zusammensetzungen oder einer Mischung aus diesen Zusammensetzungen ist:

   a) $(2-x-y)SrO \cdot x(Ba_u, Ca_v)O \cdot (1-a-b-c-d)SiO_2 \cdot aP_2O_5 \, bAl_2O_3 \, cB_2O_3 \, dGeO_2: yEu^{2+}$ wobei
   $0<=x<1.6 \, 0,005 <y< 0,5 \, x+y<=1,6$
   $0<=a,b,c,d<0,5 \, u+v=1$
   gilt,
   b) $(2-x-y)BaO \cdot x(Sr_u, Ca_v)O \cdot (1-a-b-c-d)SiO_2 \cdot aP_2O_5 \, bAl_2O_3 \, cB_2O_3 \, dGeO_2: yEu^{2+}$ wobei
   $0,01 <x< 1,6 \, 0,005 < y < 0,5$
   $0<-a,b,c,d< 0,5 \, u+v=1 \, x \cdot u>=0,4$ gilt;

   - Strahlung im gelb-grünen, gelben oder orangefarbigen Spektralbereich emittiert;
   - ein Luminophorgitter aufweist, in welches zusätzliche einwertige Ionen eingebaut sind, die durch Halogenide und/oder Alkalimetallionen gebildet sind, wobei das weiße Licht durch Mischung des transmittierenden Lichts der LED und des emittierten Lumineszenzlichts des Luminophors generiert wird.

2. Lichtquelle nach Anspruch 1, **dadurch gekennzeichnet, dass** die einwertigen Ionen als Ammoniumchlorid oder als anderes Halogenid mit einem Anteil von weniger als 0,2 Mol zugegeben sind.

3. Lichtquelle nach Anspruch 1 oder 2, **dadurch gekennzeichnet, dass** er bei Wellenlängen zwischen 510 nm und 600 nm emittiert und eine Halbwertsbreite von bis zu 110 nm besitzt.

4. Lichtquelle nach einem der Ansprüche 1 bis 3, **dadurch gekennzeichnet, dass** die mittlere Korngrösse $d_{50}$ der Volumenverteilung zwischen 2 $\mu$m und 20 $\mu$m liegt.

**Claims**

1. Light source for creating white light, including a light-emitting diode (LED) for emitting blue radiation and at least one luminophore that absorbs a portion of the blue radiation and itself emits radiation in another spectral region, **characterized in that** the luminophore

   - is an alkaline earth orthosilicate which is activated with bivalent europium and has one of the following compositions or a mixture of these compositions:

      a) $(2-x-y)SrO \cdot x(Ba_u, Ca_v)O \cdot (1-a-b-c-d)SiO_2 \cdot aP_2O_5\ bAl_2O_3\ cB_2O_3\ dGeO_2: yEu^{2+}$, where
      $0 \leq x < 1.6\ 0.005 < y < 0.5\ x+y \leq 1.6\ 0 \leq a,b,c,d < 0.5\ u+v = 1$,
      b) $(2-x-y)BaO \cdot x(Sr_u, Ca_v)O \cdot (1-a-b-c-d)SiO_2 \cdot aP_2O_5\ bAl_2O_3\ CB_2O_3\ dGeO_2: yEu^{2+}$, where
      $0.01 < x < 1.6\ 0.005 < y < 0.5$
      $0 \leq a,b,c,d < 0.5\ u+v = 1$
      $x \cdot u \geq 0.4$;

   - emits radiation in the yellow-green, yellow or orange spectral region;
   - has a luminophore lattice in which additional monovalent ions formed by halides and/or alkali metal ions are incorporated, wherein the white light is generated by mixing the transmitting light of the LED and the emitted luminescent light of the luminophore.

2. Light source according to Claim 1, **characterized in that** the monovalent ions are added as ammonium chloride or as another halide in a proportion of less than 0.2 mol.

3. Light source according to Claim 1 or 2, **characterized in that** the luminophore emits at wavelengths of between 510 nm and 600 nm and has a full width at half maximum of up to 110 nm.

4. Light source according to one of Claims 1 to 3, **characterized in that** the mean grain size $d_{50}$ of the volumetric distribution lies between 2 $\mu$m and 20 $\mu$m.

**Revendications**

1. Source lumineuse pour générer de la lumière blanche, comprenant une diode émettrice de lumière (LED) pour l'émission d'un rayonnement bleu et au moins un luminophore, qui absorbe une partie du rayonnement bleu et émet lui-même un rayonnement dans une autre plage spectrale, **caractérisée en ce qu'**il

   - est un orthosilicate alcalino-terreux activé avec de l'europium bivalent de l'une des compositions suivantes ou d'un mélange de ces compositions :

      a) $(2-x-y)SrO \cdot x(Ba_u, Ca_v)O \cdot (1-a-b-c-d)SiO_2 \cdot aP_2O_5\ bAl_2O_3\ cB_2O_3\ dGeO_2: yEu^{2+}$
      formule dans laquelle on a
      $0 \leq x < 1,6\ 0,005 < y < 0,5\ x+y \leq 1,6$
      $0 \leq a,b,c,d < 0,5\ u+v = 1$,
      b) $(2-x-y)BaO \cdot x(Sr_u, Ca_v)O \cdot (1-a-b-c-d)SiO_2 \cdot aP_2O_5\ bAl_2O_3\ cB_2O_3\ dGeO_2: yEu^{2+}$
      formule dans laquelle on a
      $0,01 < x < 1,6\ 0,005 < y < 0,5$
      $0 \leq a,b,c,d < 0,5\ u+v = 1\ x \cdot u \geq 0,4$;

   - émet un rayonnement dans la plage spectrale jaune-verte, jaune ou couleur orange;
   - présente un réseau de luminophore, dans lequel sont incorporés des ions monovalents supplémentaires, qui sont formés par des halogénures et/ou des ions de métal alcalin, la lumière blanche étant générée par un mélange de la lumière transmise de la LED et de la lumière luminescente émise du luminophore.

2. Source lumineuse selon la revendication 1, **caractérisée en ce que** les ions monovalents sont ajoutés comme chlorure d'ammonium ou comme autre halogénure avec une fraction inférieure à 0,2 Mol.

3.  Source lumineuse selon la revendication 1 ou 2, **caractérisée en ce qu'**elle émet à des longueurs d'onde entre 510 nm und 600 nm et qu'elle possède une largeur à mi-hauteur allant jusqu'à 110 nm.

4.  Source lumineuse selon l'une des revendications 1 à 3, **caractérisée en ce que** la grosseur de grain moyenne $d_{50}$ de la répartition de volume se situe entre 2 $\mu$m und 20 $\mu$m.

Fig. 1

Fig. 2

Fig. 3

Fig. 4

Fig. 5

Fig. 6

Fig. 7

Fig. 8

Fig. 9

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9805078 A
- WO 9812757 A
- WO 0033389 A
- WO 0189001 A
- WO 0019546 A
- US 3505240 A

**In der Beschreibung aufgeführte Nicht-Patentliteratur**

- **S.H.M. POORT et al.** Optical properties of Eu2+-activated orthosilicates and orthophospates. *Journal of Alloys and Compounds,* 1997, vol. 260, 93-97
- **THOMAS L BARRY.** Fluorescence of EU2+ - activated phase in binary alkaline earth orthosilicate systems. *Journal of the Electrochemical Society,* 01. November 1968, vol. 115 (11), 1181-1184